# EUROPÄISCHE PATENTSCHRIFT

(11) **EP 2 943 052 B1**
(45) Veröffentlichungstag und Bekanntmachung des Hinweises auf die Patenterteilung: **26.02.2020**
(21) Anmeldenummer: 15165972.9
(22) Anmeldetag: 30.04.2015
(51) Int. Cl.: H05K 13/04, H05K 13/08

(54) **GUTFÖRDERER FÜR EINEN BESTÜCKAUTOMATEN SOWIE BESTÜCKAUTOMAT**
GOODS CONVEYOR FOR A FILLING MACHINE AND FILLING MACHINE
TRANSPORTEUR À COURROIE POUR UN AUTOMATE D'IMPLANTATION ET AUTOMATE D'IMPLANTATION

(30) Priorität: 09.05.2014 DE 102014106543
(43) Veröffentlichungstag der Anmeldung: 11.11.2015
(73) Patentinhaber: ASM Assembly Systems GmbH & Co. KG, 81379 München (DE)
(72) Erfinder: Kühnapfel, Ralf, 81377 München (DE); Stein, Arno, 80339 München (DE)
(74) Vertreter: Patentanwälte Bals & Vogel

(56) Entgegenhaltungen:
- EP-A1- 0 226 574
- EP-A1- 1 510 115
- EP-A1- 2 293 663
- DE-A1- 10 258 844
- JP-A- 2011 082 500

## Beschreibung

Die vorliegende Erfindung betrifft einen Gurtförderer für einen Bestückautomaten, zumindest aufweisend ein drehbar gelagertes Stiftrad zum Fördern eines Gurtes, einen Antrieb mit zumindest einem Zahnrad zum Antreiben des Stiftrads und eine Positionsbestimmungsvorrichtung zum Bestimmen einer Drehposition des Stiftrads, wobei die Positionsbestimmungsvorrichtung eine erste Sensorvorrichtung mit zumindest einer magnetoresistiven Sensoranordnung aufweist. Ferner betrifft die Erfindung einen Bestückautomaten, aufweisend zumindest einen Gurtförderer.

In der modernen Technik werden vielfach elektronische Bauteile eingesetzt, die auf Platinen angeordnet sind. Um derartige Platinen in hohen Stückzahlen herstellen zu können, ist es bekannt, Bestückautomaten einzusetzen. In derartigen Bestückautomaten werden durch einen oder mehrere Bestückköpfe elektronische Bauteile auf den Platinen angeordnet. Die dafür benötigten elektronischen Bauteile werden oftmals auf sogenannten Bauteilgurten zur Verfügung gestellt, die durch Gurtförderer, die Teil der Bestückautomaten sein können, dem eigentlichen Bestückvorgang durch die Bestückköpfe zugeführt werden. In derartigen Gurtförderern erfolgt der Transport der eingelegten Gurte oftmals durch sogenannte Stifträder, deren Stifte in Perforationen der Gurte eingreifen können. Um eine sichere Funktion des Bestückautomaten sicherzustellen, insbesondere um zu gewährleisten, dass der Bestückkopf des Bestückautomaten die zugeführten elektronischen Bauteile sicher aufnehmen kann, ist eine hohe Genauigkeit der Positionierung des zugeführten Gurtes nötig. Dabei kann es notwendig sein, die absolute Winkelposition des Stiftrads des Gurtförderers mit einer Genauigkeit von ±0,035° zu bestimmen.

Es ist bekannt, bei Gurtförderern Positionsbestimmungsvorrichtungen einzusetzen, die eine magnetoresistive Sensorordnung aufweisen. In einer derartigen magnetoresistiven Sensoranordnung kann dabei beispielsweise der AMR-Effekt (anisotroper magnetoresistiver Effekt) zur Messung ausgenützt werden. Dabei ist es bekannt, direkt auf das Stiftrad ein, insbesondere als Spritzgussteil ausgebildetes, magnetisiertes Polrad aufzukleben. Bereits dieses Aufkleben des magnetisierten Polrads muss dabei mit einer hohen Präzision erfolgen. Durch die magnetoresistive Sensoranordnung der Positionsbestimmungsvorrichtung können die verschiedenen magnetischen Pole des magnetisierten Polrads gemessen und damit die Position des Stiftrads, auf dem das magnetisierte Polrad aufgeklebt ist, bestimmt werden. Dazu ist es jedoch ferner nötig, dass der Abstand zwischen der magnetoresistiven Sensoranordnung und dem Polrad während der Montage der Sensoranordnung sehr genau justiert werden muss. Dies kann beispielsweise dadurch erreicht werden, dass während der Montage die magnetoresistive Sensoranordnung in einer Gussmasse vergossen wird und in einem iterativen Verfahren der nötige Abstand zwischen der Sensoranordnung und dem magnetisierten Polrad eingestellt wird. Dieser eingestellte Abstand muss dann derartig lang sichergestellt werden, bis die Vergussmasse ausgehärtet ist. Insgesamt stellt somit die Methode und die Anordnung der Sensoranordnung zum Messen der exakten Position des Stiftsrads gemäß dem Stand der Technik, insbesondere bezüglich der Montage, eine sehr aufwendige Art und Weise dar.

Aus der EP 2 293 663 A1 eine Fördervorrichtung zum Fördern eines Bauteilgurts mit darauf angeordneten elektronischen Komponenten zu einem Bestückungsautomaten bekannt. Die Fördervorrichtung weist zwei Stifträder zum definierten Voranbewegen des Bauteilgurts auf. Die Stifträder sind jeweils integral sowie koaxial mit einem Schneckenrad und einem Phasendetektionsrad ausgebildet. Ferner weist die Fördervorrichtung magnetoresistive Sensoren auf, die zur Positionsbestimmung der Phasendetektionsräder ausgebildet sind. Die JP 2011 082500 A zeigt eine gattungsgemäße Fördervorrichtung mit einem Stiftrad, das zum Fördern eines Bauteilgurts ausgebildet ist. Das Stiftrad ist über ein Antriebsritzel drehfest sowie koaxial mit einem Detektionsrad verbunden. Mittels eines magnetoresistiven Sensors ist eine Position des Detektionsrads bestimmbar. Diese Lösungen haben ebenfalls den Nachteil, dass zum Ermitteln der Drehbewegung des Stiftrads zusätzliche Detektionsräder verwendet werden, die darüber hinaus keine weitere Funktion erfüllen.

Es ist daher Aufgabe der vorliegenden Erfindung, die voranstehend beschriebenen Nachteile bekannter Gurtförderer bzw. bekannter Bestückautomaten zumindest teilweise zu beheben. Insbesondere ist es Aufgabe der vorliegenden Erfindung, einen Gurtförderer sowie einen Bestückautomaten bereitzustellen, die eine exakte Positionsbestimmung eines Stiftrads des Gurtförderers gewährleisten, wobei insbesondere eine einfache und kostengünstige Montage der dafür nötigen Sensorvorrichtung ermöglicht ist.

Voranstehende Aufgabe wird gelöst durch einen Gurtförderer mit den Merkmalen des Anspruchs 1 sowie durch einen Bestückautomaten mit den Merkmalen des Anspruchs 10. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Gurtförderer beschrieben sind, selbstverständlich auch im Zusammenhang mit dem erfindungsgemäßen Bestückautomaten und jeweils umgekehrt, so dass bezüglich der Offenbarung zu den einzelnen Erfindungsaspekten stets wechselseitig Bezug genommen wird bzw. werden kann.

Gemäß einem ersten Aspekt der Erfindung wird die Aufgabe gelöst durch einen Gurtförderer für einen Bestückautomaten, zumindest aufweisend ein drehbar gelagertes Stiftrad zum Fördern eines Gurtes, einen Antrieb mit zumindest einem Zahnrad zum Antreiben des Stiftrads und eine Positionsbestimmungsvorrichtung zum Bestimmen einer Drehposition des Stiftrads, wobei die Positionsbestimmungsvorrichtung eine erste Sensorvorrichtung mit zumindest einer magnetoresistiven Sensoranordnung aufweist. Ein erfindungsgemäßer Gurtförderer ist dadurch gekennzeichnet, dass die erste Sensorvorrichtung dem zumindest einen Zahnrad des Antriebs zugeordnet und zum Messen einer Drehbewegung des zumindest einen Zahnrads ausgebildet ist.

Ein Gurtförderer gemäß dem Oberbegriff des Anspruchs 1 stellt einen Gurtförderer dar, der als Teil eines Bestückautomaten eingesetzt werden kann. Durch das zumindest eine drehbar gelagerte Stiftrad kann durch den Gurtförderer ein Gurt dem Bestückkopf des Bestückautomaten zugeführt werden, wobei insbesondere Stifte des Stiftrads in Perforationen des Gurtes eingreifen können. Durch den Antrieb des Gurtförderers wird dabei das Stiftrad bewegt. Um die Drehposition des Stiftrads zu bestimmen, ist im erfindungsgemäßen Gurtförderer eine Positionsbestimmungsvorrichtung mit einer Sensorvorrichtung vorgesehen, die zumindest eine magnetoresistive Sensoranordnung aufweist. Erfindungsgemäß und erfindungswesentlich ist vorgesehen, dass diese erste Sensorvorrichtung dem zumindest einen Zahnrad des Antriebs zugeordnet ist. Dadurch, dass der Antrieb zum Antreiben des Stiftrads ausgebildet ist und da das Zahnrad ein Teil des Antriebs ist, sind die Bewegungen des Zahnrads und des Stiftrads direkt oder zumindest indirekt miteinander verbunden. Eine Bewegung des Stiftrads wird somit auf eine Bewegung des Zahnrads abgebildet und umgekehrt. Durch die Zuordnung der ersten Sensorvorrichtung zum zumindest einen Zahnrad des Antriebs kann somit direkt oder zumindest indirekt auch eine Bewegung des Stiftrads ermittelt werden. Insbesondere ist es auch möglich, beispielsweise durch einen Start der Bewegung des zumindest einen Zahnrads aus einer definierten Drehposition und einer inkrementellen Messung der Drehbewegung des zumindest einen Zahnrads, zu jederzeit ein absolute Drehposition des zumindest einen Zahnrads zu bestimmen. Dies ist insbesondere darin begründet, dass die erste Sensorvorrichtung zum Messen einer Drehbewegung des zumindest einen Zahnrads ausgebildet ist. Dabei ist insbesondere die erste Sensorvorrichtung derart dem Zahnrad zugeordnet, dass bereits die Bewegung der Zähne des Zahnrads in der Nähe der ersten Sensorvorrichtung, insbesondere in der Nähe der zumindest einen magnetoresistiven Sensoranordnung der ersten Sensorvorrichtung, ausreicht, um durch die magnetoresistive Sensoranordnung genügend große Signale zu erzeugen, die zum Messen der Drehbewegung des zumindest einen Zahnrads ausreichend sind. Insbesondere durch die Zuordnung der ersten Sensorvorrichtung an dem zumindest einen Zahnrad kann auf das aufwendige Ankleben eines magnetisierten Polrads direkt auf das Stiftrad des Gurtförderers verzichtet werden. Bereits dadurch wird die Montage der Positionsbestimmungsvorrichtung innerhalb des Gurtförderers vereinfacht. Auch können eventuell für die Durchführung der Messung nötige Magneten, die bevorzugt als Teil der ersten Sensorvorrichtung aber auch direkt am zumindest einen Zahnrad angeordnet sein können, weiter vom Stiftrad entfernt platziert werden, als es bei Gurtförderern gemäß dem Stand der Technik möglich ist. Eine mögliche Beeinflussung der auf dem Gurt angeordneten elektronischen Bauteile durch das Magnetfeld eines derartigen Magneten der ersten Sensorvorrichtung kann dadurch vermieden oder zumindest deutlich vermindert werden. Eine geringere Beeinflussung der Bauteile im Gurt kann dadurch sichergestellt werden, wodurch auch Bauteile verwendet werden können, die eine hohe Beeinflussbarkeit durch magnetische Felder aufweisen. Insgesamt kann durch einen erfindungsgemäßen Gurtförderer durch die Verwendung einer dem zumindest einen Zahnrad zugeordneten Sensorvorrichtung zum Messen einer Drehbewegung des zumindest einen Zahnrads eine deutliche Vereinfachung bei der Montage und der Herstellung des gesamten Gurtförderers bei gleichzeitiger Sicherstellung einer exakten Messbarkeit der Position des Stiftrads des Gurtförderers erreicht werden.

Ferner kann bei einem erfindungsgemäßen Gurtförderer vorgesehen sein, dass das zumindest eine Zahnrad des Antriebs mit dem Stiftrad fest verbunden ist, insbesondere stoffschlüssig verbunden ist, bevorzugt verschweißt ist. Befindet sich das Zahnrad mechanisch weit entfernt vom Stiftrad, so kann es durch beispielsweise mechanische Übertragungsverluste zu leichten Abweichungen der Zahnrad- von der Stiftradbewegung kommen. Durch eine feste Verbindung zwischen dem zumindest einen Zahnrad und dem Stiftrad kann dies vermieden werden. Durch eine stoffschlüssige Verbindung kann eine derartige feste Verbindung zwischen dem zumindest einen Zahnrad des Antriebs und dem Stiftrad besonders einfachsichergestellt werden. Besonders ein Verschweißen stellt dabei eine besonders feste stoffschlüssige Verbindungsart dar. Eine besonders gute und exakte Bestimmung der Drehposition des Stiftrads durch ein Messen der Drehposition des Zahnrads kann dadurch erreicht werden.

Auch kann ein erfindungsgemäßer Gurtförderer dahingehend ausgebildet sein, dass die erste Sensorvorrichtung derart bezüglich des zumindest einen Zahnrads angeordnet ist, dass es dem zumindest einen Zahnrad radial zugeordnet ist. Damit ist die erste Sensorvorrichtung insbesondere die zumindest eine magnetoresistive Sensoranordnung der ersten Sensorvorrichtung, einer umfänglichen Seite des zumindest einen Zahnrads zugeordnet. Die Zähne des Zahnrads werden somit bei einer Drehbewegung des Zahnrads an der zumindest einen magnetoresistiven Sensoranordnung der ersten Sensorvorrichtung vorbeigeführt. Durch die Zähne des Zahnrads und durch die dazwischenliegenden Täler ergeben sich somit besonders große Abstandsänderungen, die sich in besonders großen und deutlichen, durch die zumindest eine magnetoresistive Sensoranordnung gemessenen, Signalen widerspiegelt. Große elektronische Verstärkungen der Signale können dadurch vermieden werden oder sind zumindest nur eingeschränkt nötig. Eine deutlich bessere Signalqualität beim Messen kann dadurch erreicht werden, wodurch auch die Präzision bei der Bestimmung der Drehposition des Zahnrads und damit des Stiftrads erreicht werden kann.

Besonders bevorzugt kann bei einem erfindungsgemäßen Gurtförderer vorgesehen sein, dass die zumindest eine magnetoresistive Sensoranordnung zum Messen einer durch den GMR-Effekt erzeugten Änderung eines elektrischen Widerstands ausgebildet ist. Der GMR-Effekt (giant magnetoresistance effect) stellt einen quantenmechanischen Effekt dar, bei dem der elektrische Widerstand eines Materials sehr deutlich von einer Richtung abhängt, in der Magnetfeldlinien durch dieses Material verlaufen. Dadurch, dass die erste Sensorvorrichtung und insbesondere die zumindest eine magnetoresistive Sensoranordnung der ersten Sensorvorrichtung dem zumindest einen Zahnrad des Antriebs zugeordnet ist, bewegen sich die Zähne des Zahnrads an der ersten Sensorvorrichtung vorbei. Magnetfeldlinien eines Magneten, der beispielsweise bevorzugt derart angeordnet sein kann, dass sich die zumindest eine magnetoresistive Sensoranordnung zwischen dem Zahnrad und dem Magneten befindet, werden durch die vorbeigeführten Zähne des Zahnrads beeinflusst. Durch die Ausnützung des GMR-Effekts kann diese Beeinflussung durch eine Messung des elektrischen Widerstands gemessen werden. Durch die Verwendung einer derartigen magnetoresistiven Sensoranordnung, die zum Messen einer durch dem GMR-Effekt erzeugten Änderung eines elektrischen Widerstands ausgebildet ist, kann somit ein besonders gutes und großes Signal erzeugt werden, das die Bewegung des Zahnrads bzw. dessen Zähne abbildet. Insbesondere dadurch kann auch auf ein Aufbringen von Magneten auf das Zahnrad, beispielsweise durch das Aufkleben eines magnetisierten Polrads, verzichtet werden. Die Montage eines erfindungsgemäßen Gurtförderers wird dadurch nochmals vereinfacht, wobei gleichzeitig die Messgenauigkeit erhöht werden kann.

Auch kann bei einem erfindungsgemäßen Gurtförderer vorgesehen sein, dass die erste Sensorvorrichtung zwei gegeneinander verdrehte, insbesondere um 45° verdrehte, magnetoresistive Sensoranordnungen aufweist. Dadurch kann insbesondere eine nochmalige Steigerung der Messgenauigkeit, die durch die erste Sensorvorrichtung erreicht werden kann, bereitgestellt werden. Dies ist zum einen dadurch begründet, dass die Bewegung des Zahnrads durch zwei magnetoresistive Sensoranordnungen gemessen wird. Durch diese doppelte Messung kann insbesondere der Messfehler deutlich verringert werden. Zum anderen sind die beiden magnetoresistiven Sensoranordnungen gegeneinander verdreht. Dadurch liefern die beiden magnetoresistiven Sensoranordnungen systematisch gegeneinander versetzte Messergebnisse, wodurch wiederum die kombinierte Messgenauigkeit der ersten Sensorvorrichtung gesteigert werden kann. Beispielsweise können die beiden magnetoresistiven Sensoranordnungen jeweils als eine Wheatstone'sche Brückenschaltung ausgebildet sein, wobei die jeweils vier Widerstände der Brückenschaltungen um 45° gegeneinander verdreht sein können. Die Messsignale der beiden Brückenschaltungen sind in diesem Fall im Wesentlichen sinus- bzw. kosinusförmig. Durch einen Vergleich der beiden Messungen bei der Auswertung der Messungen kann im Folgenden insgesamt die Position des Zahnrads und damit die Drehposition des Stiftrads besonders genau ermittelt werden.

Besonders bevorzugt kann beim erfindungsgemäßen Gurtförderer vorgesehen sein, dass die erste Sensorvorrichtung zumindest eine Platine mit wenigstens einer Kante aufweist, wobei die zumindest eine magnetoresistive Sensoranordnung auf der Platine mit einem definierten Abstand zu der wenigsten einen Kante angeordnet ist und wobei der definierte Abstand eine Genauigkeit kleiner 0,150 mm, bevorzugt kleiner 0,050 mm, aufweist. Beispielsweise kann die zumindest eine magnetoresistive Sensoranordnung dabei mit einem definierten Abstand von 0,050 mm von der Kante platziert werden, wodurch sie bei der bevorzugten Genauigkeit von kleiner 0,050 mm derart auf der Platine angeordnet ist, dass sie bündig mit der Kante angeordnet sein kann, aber maximal 0,100 mm von der Kante entfernt angeordnet ist. Insbesondere durch die Anordnung der zumindest einen magnetoresistiven Sensoranordnung auf der Platine der ersten Sensorvorrichtung ist es möglich, einen Teil der nötigen Genauigkeit bei der Positionierung der Sensorvorrichtung bezüglich des Zahnrads bereits durch die exakte Platzierung der magnetoresistiven Sensoranordnung auf der Platine zu erreichen. Die Herstellung derartiger Platinen ist ein Standardverfahren, wodurch diese nötige Genauigkeit besonders einfach erreicht werden kann. Insbesondere die Herstellung des gesamten Gurtförderers, bei dem diese Genauigkeit bei der Platzierung der zumindest einen magnetoresistiven Sensoranordnung bezüglich des Zahnrads erreicht werden muss, wird dadurch die Herstellung erleichtert. Eine Reduktion der Kosten bei der Herstellung und Montage des gesamten Gurtförderers kann dadurch erreicht werden.

Besonders bevorzugt kann in einer Weiterentwicklung eines erfindungsgemäßen Gurtförderers vorgesehen sein, dass der Antrieb zumindest eine Anschlagfläche aufweist und die erste Sensorvorrichtung derart angeordnet ist, dass die wenigstens eine Kante der Platine die zumindest eine Anschlagfläche kontaktiert, insbesondere dass die wenigstens eine Kante der Platine gegen die zumindest eine Anschlagfläche gedrückt ist. Durch eine derartige Anschlagfläche wird die Montage der ersten Sensorvorrichtung innerhalb des Gurtförderers nochmals erleichtert, wobei gleichzeitig die Anforderungen an die Präzision des Einbaus noch leichter eingehalten werden können. Dadurch, dass die Kante der Platine die zumindest eine Anschlagfläche kontaktiert, kann die Genauigkeit der Platzierung der zumindest einen magnetoresistiven Sensoranordnung auf der Platine auch auf die Platzierung der ersten Sensorvorrichtung innerhalb des Gurtförderers übertragen werden. Insbesondere durch ein Drücken der Kante der Platine gegen die zumindest eine Anschlagfläche bei der Montage der ersten Sensorvorrichtung im Gurtförderer kann dies sichergestellt werden. Eine besonders hohe Präzision bei der Montage der ersten Sensorvorrichtung im Gurtförderer kann dadurch besonders einfach und reproduzierbar erreicht werden.

Darüber hinaus kann ein erfindungsgemäßer Gurtförderer dahingehend ausgebildet sein, dass die Positionsbestimmungsvorrichtung eine zweite Sensorvorrichtung zum Erkennen einer vollständigen Umdrehung des zumindest einen Zahnrads des Antriebs und/oder des Stiftrads aufweist. Dadurch ist es möglich, auf besonders einfache Art und Weise eine vollständige Umdrehung des Stiftrads zu erkennen. Eine besonders einfache Bestimmung der absoluten Position des Stiftrads ist dadurch ermöglicht. Insbesondere kann dadurch beispielsweise eine Elektronik, die zur Auswertung der Sensorsignale sowohl der ersten als auch der zweiten Sensorvorrichtung verwendet wird, vereinfacht werden. Insbesondere kann auch vermieden werden, den gemäß dem Stand der Technik vorgesehenen Magneten am Stiftrad, der für eine Messung einer vollständigen Umdrehung durch eine Hall-Sonde nötig ist, anbringen zu müssen. Eine Beeinflussung der im Gurt transportierten elektronischen Bauteile durch magnetische Felder kann dadurch weiter vermindert werden.

Gemäß einer bevorzugten Weiterentwicklung eines erfindungsgemäßen Gurtförderers kann ferner vorgesehen sein, dass die zweite Sensorvorrichtung einen Lichtsensor, insbesondere eine Reflexlichtschranke, umfasst. Ein derartiger Lichtsensor, insbesondere eine Reflexlichtschranke, stellt dabei eine besonders einfache Möglichkeit dar, eine vollständige Umdrehung des Zahnrads und/oder des Stiftrads zu erkennen. Dafür kann beispielsweise ein auf das Zahnrad und/oder das Stiftrad aufgeklebter Reflexpunkt verwendet werden, dessen Durchgang vor dem Lichtsensor bzw. der Reflexlichtschranke gemessen werden kann. Insbesondere durch einen Lichtsensor kann dabei eine Messung des Durchgangs eines kompletten Umlaufs des Zahnrads bzw. des Stiftrads ohne Einfluss auf die geförderten elektronischen Bauteile durchgeführt werden.

Gemäß einem zweiten Aspekt der Erfindung wird die Aufgabe gelöst durch einen Bestückautomaten, aufweisend zumindest einen Gurtförderer. Ein erfindungsgemäßer Bestückautomat ist dadurch gekennzeichnet, dass der Gurtförderer gemäß dem ersten Aspekt der Erfindung ausgebildet ist. Dementsprechend bringt ein erfindungsgemäßer Bestückautomat die gleichen Vorteile mit sich, wie sich ausführlich mit Bezug auf einen Gurtförderer gemäß dem ersten Aspekt der Erfindung erläutert worden sind.

Weitere Vorteile, Merkmale und Einzelheiten der Erfindung ergeben sich aus der nachfolgenden Beschreibung, in der unter Bezugnahme auf die Zeichen Ausführungsbeispiele der Erfindung im Einzelnen beschrieben sind. Elemente mit gleicher Funktion und Wirkungsweise sind in den einzelnen Figuren mit denselben Bezugszeichen versehen. Es zeigen schematisch:
- Fig. 1: eine Teilansicht einer Positionsbestimmungsvorrichtung eines erfindungsgemäßen Gurtförderers,
- Fig. 2: eine Teilansicht eines erfindungsgemäßen Gurtförderers und
- Fig. 3: eine Schnittansicht eines Teils eines erfindungsgemäßen Gurtförderers.

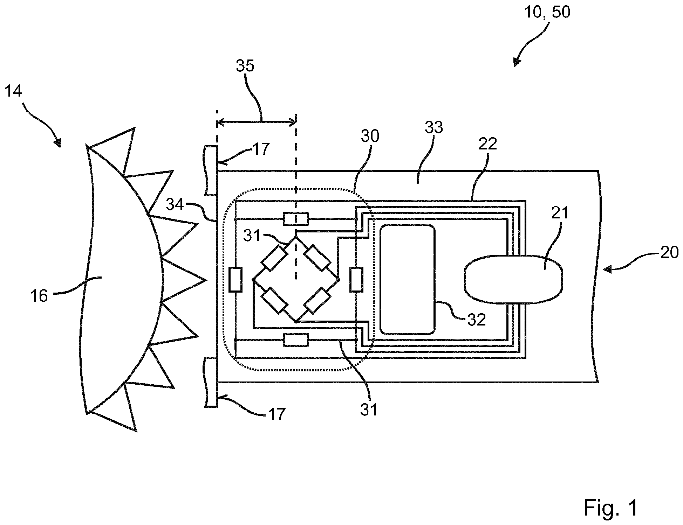

Fig. 1 zeigt einen Teil eines erfindungsgemäßen Gurtförderers 10, der in einem Bestückautomaten 50 verbaut ist. Insbesondere sind Teile einer Positionsbestimmungsvorrichtung 20 gezeigt. Die Positionsbestimmungsvorrichtung 20 weist dabei insbesondere eine erste Sensorvorrichtung 30 auf, die im Wesentlichen als Platine 33 sichtbar ist. Auf dieser Platine 33 sind zwei magnetoresistive Sensoranordnungen 31 angeordnet, die jeweils als Wheatstone'sche Brückenschaltungen ausgebildet sind. Die beiden magnetoresistiven Sensoranordnungen 31 sind dabei derart auf der Platine 33 angeordnet, dass sie einen definierten Abstand 35 von einer Kante 34 der Platine 33 aufweisen. Es ist dabei vorgesehen, dass der definierte Abstand 35 mit einer Genauigkeit von bevorzugt besser als 0,050 mm bestimmt ist. Die beiden magnetoresistiven Sensoranordnungen 31 sind mit elektrischen Verbindungen 22 mit einer Auswerteelektronik 21 der Positionsbestimmungsvorrichtung 20 verbunden. Darüber hinaus sind die beiden magnetoresistiven Sensoranordnungen 31 derart auf der Platine 33 angeordnet, dass sie sich zwischen einem ebenfalls auf der Platine 33 angeordneten Magneten 32 und einem Zahnrad 16 eines Antriebs 14 des Gurtförderers 10 befinden. Eine Bewegung des Zahnrads 16 bewirkt dadurch eine Änderung der Magnetfeldlinien, die vom Magneten 32 zum Zahnrad 16 verlaufen. Dadurch, dass die erste Sensorvorrichtung 30 eben diese zwei magnetoresistiven Sensoranordnungen 31 aufweist, bewirken diese Änderungen in den Magnetfeldlinien eine Änderung des elektrischen Widerstands der in den magnetoresistiven Sensoranordnungen 31 verbauten elektrischen Widerstände. Dies kann durch die Auswerteelektronik 21 gemessen und ausgewertet werden, so dass die Bewegung des Zahnrads 16 gemessen werden kann. Besonders bevorzugt ist dabei das Zahnrad 16 fest mit einem Stiftrad 12 des Gurtförderers 10 (nicht mit abgebildet) verbunden, wodurch automatisch auch eine Drehposition des Stiftrads 12 zu jeder Zeit bestimmbar ist. Dadurch kann sichergestellt werden, dass durch den Gurtförderer 10 einem Bestückkopf des Bestückautomaten 50 (nicht mit abgebildet) in einem Gurt 11 (nicht mit abgebildet) zugeführten Bauteile an definierten und festen Positionen bereitgestellt werden. Darüber hinaus weist in der abgebildeten Ausgestaltungsform eines erfindungsgemäßen Gurtförderers 10 der Antrieb 14 zwei Anschlagflächen 17 auf. Die Platine 33 der ersten Sensorvorrichtung 30 ist dabei derart im Gurtförderer 10 platziert, dass die Kante 34 der Platine 33 an diese beiden Anschlagflächen 17 gedrückt ist. Dadurch kann sichergestellt werden, dass die genaue Positionierung der magnetoresistiven Sensoranordnungen 31, die durch den definierten Abstand 35 sichergestellt ist, auch auf eine genaue Positionierung der gesamten ersten Sensorvorrichtung 30 bezüglich des Zahnrads 16 des Antriebs 14 übertragen werden kann. Eine besonders genaue und sichere Messung der Drehposition des Zahnrads 16 kann dadurch besonders einfach sichergestellt werden. Aufwendige Verklebungsvorgänge oder das Umgießen der Platine 33 mit einem Vergussmittel und eine Stabilisierung der Platine 33 bis zu einem Aushärten des Vergussmittels können dadurch vermieden werden.

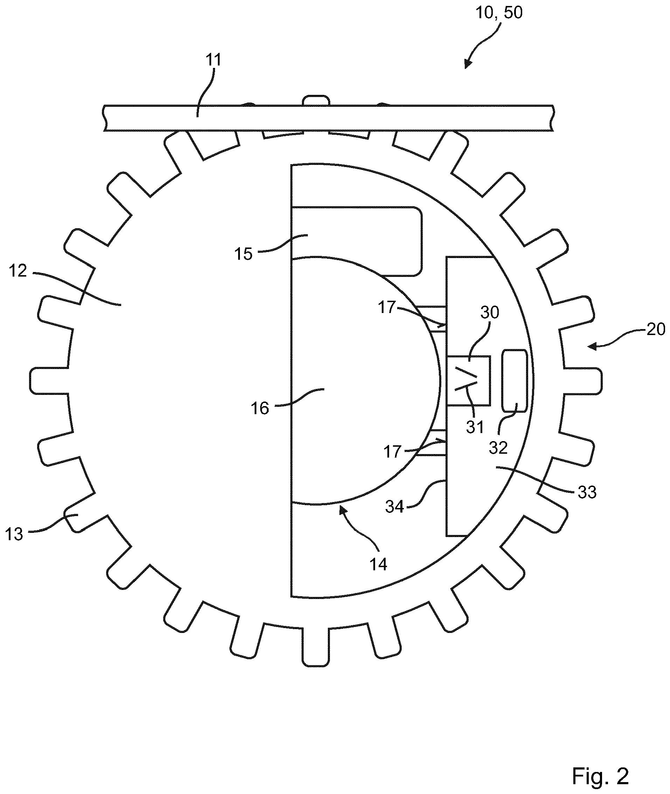

Fig. 2 zeigt eine weitere Ansicht eines erfindungsgemäßen Gurtförderers 10 der in einem Bestückautomaten 50 verbaut ist. Insbesondere ist in dieser Abbildung auch das Stiftrad 12 zu sehen. Zur besseren Anschaulichkeit ist der mittlere Abschnitt des Stiftrads 12 teilweise ausgeblendet. Die Stifte 13 des Stiftrads 12, von denen nur ein einziger Stift 13 mit einem Bezugszeichen versehen ist, sind zum Eingreifen in Perforationen des Gurtes 11 ausgebildet. Bei einer Bewegung des Stiftrads 12 wird somit der Gurt 11 weiterbewegt, wodurch einem Bestückkopf des Bestückautomaten 50 (nicht mit abgebildet) sukzessive die auf dem Gurt 11 angeordneten elektronischen Bauteile zugeführt werden können. Der Antrieb 14 des Gurtförderers 10 ist dabei für ein Antreiben des Stiftrads 12 vorgesehen. Er weist beispielsweise ein Schneckenrad 15 auf, durch das ein Zahnrad 16 angetrieben wird. Das Zahnrad 16 ist dabei bevorzugt mit dem Stiftrad 12 fest verbunden, insbesondere verschweißt. Bei einer Bewegung des Zahnrads 16 wird somit automatisch auch das Stiftrad 12 bewegt, wobei insbesondere die beiden Bewegungen direkt miteinander verbunden sind und aufeinander abgebildet werden. Ferner weist der Antrieb 14 zwei Anschlagflächen 17 auf, an die eine Kante 34 einer Platine 33 einer ersten Sensorvorrichtung 30 angedrückt werden können. Auf dieser Platine 33 ist ferner zumindest eine magnetoresistive Sensoranordnung 31 angeordnet. Die magnetoresistive Sensoranordnung 31 kann dabei derart auf der Platine 33 angeordnet sein, dass ein definierter Abstand 35 (nicht mit eingezeichnet) von der Kante 34 eingehalten wird. Eine besonders genaue Platzierung der magnetoresistiven Sensoranordnung 31 auf der Platine kann dadurch erreicht werden. Durch das Kontaktieren, insbesondere das Andrücken der Kante 34 an die Anschlagflächen 17 kann diese genaue Platzierung der magnetoresistiven Sensoranordnung 31 auch bezüglich des Zahnrads 16 erreicht werden. Eine besonders genaue Messung der Drehbewegung des Zahnrads 16 durch die erste Sensorvorrichtung 30, insbesondere die magnetoresistive Sensoranordnung 31 der ersten Sensorvorrichtung 30, kann dadurch erreicht werden. Darüber hinaus ist auch sichtbar, dass die magnetoresistive Sensoranordnung 31 zwischen einem Magneten 32 auf der Platine 33 und dem Zahnrad 16 angeordnet ist. Magnetfeldlinien des Magnets 32 werden durch die Bewegung des Zahnrads 16 verändert, wobei diese Veränderung durch die magnetoresistive Sensoranordnung 31 gemessen werden kann. Eine genaue Bestimmung der Drehposition des Zahnrads 16 ist somit zu jeder Zeit möglich. Insbesondere kann auch die absolute Position des Zahnrads 16 ermittelt werden, beispielsweise durch eine Auswertung der bereits vorbeibewegten Zähne des Zahnrads 16 und einem Start bei einer definierten Nullposition des Zahnrads 16. Selbstverständlich kann auch eine zweite Sensorvorrichtung 40 (nicht mit abgebildet) vorgesehen sein, um eben den definierten Nulldurchgang des Zahnrads 16 bzw. des Stiftrads 12 zu bestimmen.

In Fig. 2 weist die erste Sensorvorrichtung 30 zwei um 45° gegeneinander verdrehte magnetoresistive Sensoranordnungen 31 auf. Hierdurch kann eine nochmalige Steigerung der Messgenauigkeit, die durch die erste Sensorvorrichtung 30 erreicht werden kann, bereitgestellt werden. Das heißt, die Bewegung des Zahnrads 16 wird durch zwei zueinander verdrehte magnetoresistive Sensoranordnungen 31 gemessen. Durch diese doppelte Messung kann der Messfehler deutlich verringert werden. Durch die Verdrehung der beiden magnetoresistiven Sensoranordnungen 31 gegeneinander, insbesondere um 45°, können die beiden magnetoresistiven Sensoranordnungen 31 systematisch gegeneinander versetzte Messergebnisse liefern, wodurch wiederum die kombinierte Messgenauigkeit der ersten Sensorvorrichtung 30 gesteigert werden kann. Vorzugsweise sind die beiden magnetoresistiven Sensoranordnungen 31 jeweils als eine Wheatstone'sche Brückenschaltung ausgebildet, wobei die jeweils vier Widerstände der Brückenschaltungen um 45° gegeneinander verdreht sein können. Die Messsignale der beiden Brückenschaltungen sind in diesem Fall im Wesentlichen sinus- bzw. kosinusförmig. Durch einen Vergleich der beiden Messungen bei der Auswertung der Messungen kann im Folgenden insgesamt die Position des Zahnrads 16 und damit die Drehposition des Stiftrads 12 besonders genau ermittelt werden

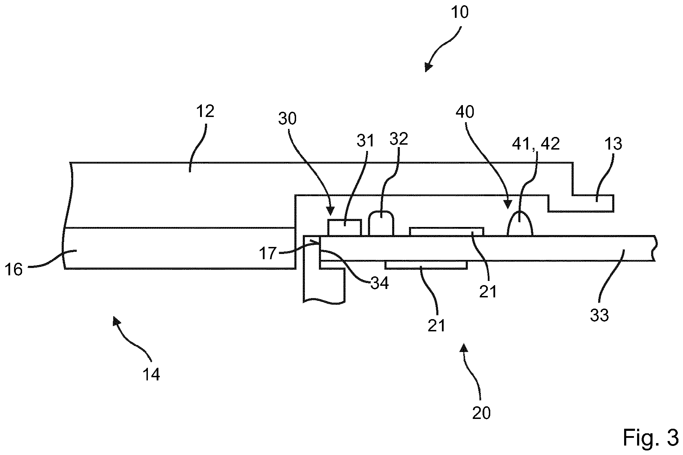

In Fig. 3 ist eine Schnittansicht einer weiteren Ausgestaltungsform eines erfindungsgemäßen Gurtförderers 10 gezeigt. Hier ist insbesondere deutlich sichtbar, dass das Zahnrad 16 und das Stiftrad 12 fest miteinander verbunden sind. Die Stifte 13 des Stiftrads 12 befinden sich am äußeren Rand des Stiftrads 12. Neben dem Antrieb 14 ist auch eine Positionsbestimmungsvorrichtung 20 gezeigt. Die Positionsbestimmungsvorrichtung 20 weist dabei insbesondere eine erste Sensorvorrichtung 30 mit einer magnetoresistiven Sensoranordnung 31 und einem Magneten 32 auf. Diese Bauteile der ersten Sensorvorrichtung 30 sind dabei auf einer Platine 33 angeordnet, insbesondere in einem definierten Abstand 35 (nicht mit abgebildet) zu einer Kante 34 der Platine. Diese Kante 34 der Platine ist wiederum gegen eine Anschlagfläche 17 des Antriebs 14 gedrückt. Eine genaue Positionierung insbesondere der magnetoresistiven Sensoranordnung 31 bezüglich des Zahnrads 16 kann dadurch erreicht werden. Darüber hinaus weist die Positionsbestimmungsvorrichtung 20 neben einer Auswerteelektronik 21 auch eine zweite Sensorvorrichtung 40 auf. Diese zweite Sensorvorrichtung 40 umfasst insbesondere einen als Reflexlichtschranke 42 ausgebildeten Lichtsensor 41. Dieser Lichtsensor 41 ist zum Beobachten des Stiftrads 12 ausgebildet, wobei beispielsweise auf dem Stiftrad 12 ein mattschwarzes Label als Reflexobjekt aufgeklebt sein kann. Bei einer Bewegung dieses Reflexpunktes über die Reflexlichtschranke 42 kann somit eine vollständige Umdrehung des Stiftrads 12 ermittelt werden. Eine besonders einfache Bestimmung eines vollständigen Umlaufs des Stiftrads 12 und basierend darauf, zusammen mit der Messung der magnetoresistiven Sensoranordnung 31 am Zahnrad 16, der absoluten Position des Stiftrads 12 kann dadurch erreicht werden.

### Liste der Bezugszeichen und Symbole

10 Gurtförderer
11 Gurt
12 Stiftrad
13 Stift
14 Antrieb
15 Schneckenrad
16 Zahnrad
17 Anschlagfläche
20 Positionsbestimmungsvorrichtung
21 Auswerteelektronik
22 Elektrische Verbindung
30 Erste Sensorvorrichtung
31 Magnetoresistive Sensoranordnung
32 Magnet
33 Platine
34 Kante
35 Definierter Abstand
40 Zweite Sensorvorrichtung
41 Lichtsensor
42 Reflexlichtschranke
50 Bestückautomat

Die vorstehende Liste ist integraler Bestandteil der Beschreibung.

## Patentansprüche

1. Gurtförderer (10) für einen Bestückautomaten (50), zumindest aufweisend ein drehbar gelagertes Stiftrad (12) zum Fördern eines Gurtes (11), einen Antrieb (14) mit zumindest einem mehrere Zähne aufweisenden Zahnrad (16) zum Antreiben des Stiftrads (12) und eine Positionsbestimmungsvorrichtung (20) zum Bestimmen einer Drehposition des Stiftrads (12), wobei die Positionsbestimmungsvorrichtung (20) eine erste Sensorvorrichtung (30) mit zumindest einer magnetoresistiven Sensoranordnung (31) aufweist, wobei die erste Sensorvorrichtung (30) dem zumindest einen Zahnrad (16) des Antriebs (14) zugeordnet und zum Messen einer Drehbewegung des zumindest einen Zahnrads (16) ausgebildet ist **dadurch gekennzeichnet,**
**dass**
die erste Sensorvorrichtung (30) derart dem zumindest einen Zahnrad (16) zugeordnet ist, dass eine Bewegung der Zähne des zumindest einen Zahnrads (16) ausreicht, um durch die magnetoresistive Sensoranordnung (31) genügend große Signale zu erzeugen, die zum Messen der Drehbewegung des zumindest einen Zahnrads (16) ausreichend sind.

2. Gurtförderer (10) gemäß Anspruch 1,
**dadurch gekennzeichnet,**
**dass** das zumindest eine Zahnrad (16) des Antriebs (14) mit dem Stiftrad (12) fest verbunden ist, insbesondere stoffschlüssig verbunden ist, bevorzugt verschweißt ist.

3. Gurtförderer (10) gemäß einem der vorangegangenen Ansprüche,
**dadurch gekennzeichnet,**
**dass** die erste Sensorvorrichtung (30) derart bezüglich des zumindest einen Zahnrads (16) angeordnet ist, dass es dem zumindest einem Zahnrad (16) radial zugeordnet ist, wobei die zumindest eine magnetoresistive Sensoranordnung (31) der ersten Sensorvorrichtung (30) einer umfänglichen Seite des zumindest einen Zahnrads (16) derart zugeordnet ist, dass die Zähne des zumindest einen Zahnrads (16) bei einer Drehbewegung des mindestens einen Zahnrads (16) an der zumindest einen magnetoresistiven Sensoranordnung (31) der ersten Sensorvorrichtung (30) vorbeigeführt werden.

4. Gurtförderer (10) gemäß einem der vorangegangenen Ansprüche,
**dadurch gekennzeichnet,**
**dass** die zumindest eine magnetoresistive Sensoranordnung (31) zum Messen einer durch den GMR-Effekt erzeugten Änderung eines elektrischen Widerstands ausgebildet ist.

5. Gurtförderer (10) gemäß einem der vorangegangenen Ansprüche,
**dadurch gekennzeichnet,**
**dass** die erste Sensorvorrichtung (30) zwei gegeneinander verdrehte, insbesondere um 45° verdrehte, magnetoresistive Sensoranordnungen (31) aufweist.

6. Gurtförderer (10) gemäß einem der vorangegangenen Ansprüche,
**dadurch gekennzeichnet,**
**dass** die erste Sensorvorrichtung (30) zumindest eine Platine (33) mit wenigstens einer Kante (34) aufweist, wobei die zumindest eine magnetoresistive Sensoranordnung (31) auf der Platine (33) mit einem definierten Abstand (35) zu der wenigstens einen Kante (34) angeordnet ist und wobei der definierte Abstand (35) eine Genauigkeit kleiner 0,150 mm, bevorzugt kleiner 0,050 mm, aufweist.

7. Gurtförderer (10) gemäß Anspruch 6,
**dadurch gekennzeichnet,**
**dass** der Antrieb (14) zumindest eine Anschlagfläche (17) aufweist und die erste Sensorvorrichtung (30) derart angeordnet ist, dass die wenigstens eine Kante (34) der Platine (33) die zumindest eine Anschlagfläche (17) kontaktiert, insbesondere dass die wenigstens eine Kante (34) der Platine (33) gegen die zumindest eine Anschlagfläche (17) gedrückt ist.

8. Gurtförderer (10) gemäß einem der vorangegangenen Ansprüche,
**dadurch gekennzeichnet,**
**dass** die Positionsbestimmungsvorrichtung (20) eine zweite Sensorvorrichtung (40) zum Erkennen einer vollständigen Umdrehung des zumindest einen Zahnrads (16) des Antriebs (14) und/oder des Stiftrads (12) aufweist.

9. Gurtförderer (10) gemäß Anspruch 8,
**dadurch gekennzeichnet,**
**dass** die zweite Sensorvorrichtung (40) einen Lichtsensor (41), insbesondere eine Reflexlichtschranke (42), umfasst.

10. Bestückautomat (50), aufweisend zumindest einen Gurtförderer (10),
**dadurch gekennzeichnet,**
**dass** der Gurtförderer (10) gemäß einem der vorangegangenen Ansprüche ausgebildet ist.

## Claims

1. Belt conveyor (10) for a mounting machine (50), at least comprising a rotatably mounted pin wheel (12) for conveying a belt (11), a drive (14) with at least one gear wheel (16) having a plurality of teeth for driving the pin wheel (12) and a position determining device (20) for determining a rotational position of the pin wheel (12), wherein the position determining device (20) comprises a first sensor device (30) with at least one magnetoresistive sensor arrangement (31), wherein
the first sensor device (30) is associated with the at least one gear wheel (16) of the drive (14) and is adapted to measure a rotational movement of the at least one gear wheel (16), **characterized in that**
the first sensor device (30) is associated with the at least one gear wheel (16) such that a movement of the teeth of the at least one gear wheel (16) is sufficient to generate sufficiently large signals through the magnetoresistive sensor arrangement (31) which are sufficient to measure the rotational movement of the at least one gear wheel (16).

2. Belt conveyor (10) according to claim 1,
**characterized in that**
the at least one gear wheel (16) of the drive (14) is firmly connected to the pin wheel (12), in particular connected in a material-locking manner, preferably welded.

3. Belt conveyor (10) according to one of the preceding claims,
**characterized in that**
the first sensor device (30) is arranged with respect to the at least one gear wheel (16) in such a way that it is radially assigned to the at least one gear wheel (16), wherein the at least one magnetoresistive sensor arrangement (31) of the first sensor device (30) is assigned to a peripheral side of the at least one gear wheel (16) in such a way that the teeth of the at least one gear wheel (16) are guided past the at least one magnetoresistive sensor arrangement (31) of the first sensor device (30) during a rotational movement of the at least one gear wheel (16).

4. Belt conveyor (10) according to one of the preceding claims,
**characterized in that**
the at least one magnetoresistive sensor arrangement (31) is configured to measure a change in an electrical resistance generated by the GMR effect.

5. Belt conveyor (10) according to one of the preceding claims,
**characterized in that**
the first sensor device (30) has two magnetoresistive sensor arrangements (31) which are rotated relative to one another, in particular through 45°.

6. Belt conveyor (10) according to one of the preceding claims,
**characterized in that**
the first sensor device (30) has at least one printed circuit board (33) with at least one edge (34), wherein the at least one magnetoresistive sensor arrangement (31) is arranged on the printed circuit board (33) at a defined distance (35) from the at least one edge (34), and wherein the defined distance (35) has an accuracy of less than 0.150 mm, preferably less than 0.050 mm.

7. Belt conveyor (10) according to claim 6,
**characterized in that**
the drive (14) has at least one stop face (17) and the first sensor device (30) is arranged such that the at least one edge (34) of the printed circuit board (33) contacts the at least one stop face (17), in particular **in that** the at least one edge (34) of the printed circuit board (33) is pressed against the at least one stop face (17).

8. Belt conveyor (10) according to one of the preceding claims,
**characterized in that**
the position determining device (20) has a second sensor device (40) for detecting a complete rotation of the at least one
gearwheel (16) of the drive (14) and/or of the pin wheel (12).

9. Belt conveyor (10) according to claim 8,
**characterized in that**
the second sensor device (40) comprises a light sensor (41), in particular a reflex light barrier (42).

10. Mounting machine (50) having at least one belt conveyor (10),
**characterized in that**
the belt conveyor (10) is configured according to one of the preceding claims.

## Revendications

1. Convoyeur à courroie (10) pour une machine d'insertion automatique (50), comprenant au moins une roue à tenons (12) montée de manière rotative pour convoyer une courroie (11), un entraînement (14) ayant au moins une roue dentée (16) comportant plusieurs dents pour entraîner la roue à tenons (12) et un dispositif de détermination de position (20) pour déterminer une position de rotation de la roue à tenons (12), le dispositif de détermination de position (20) comportant un premier dispositif formant capteur (30) comportant au moins un ensemble capteur magnétorésistif (31), le premier dispositif formant capteur (30) étant associé à l'au moins une roue dentée (16) de l'entraînement (14), et étant conçu pour mesurer un mouvement de rotation de l'au moins une roue dentée (16), **caractérisé en ce que** le premier dispositif formant capteur (30) est associé à l'au moins une roue dentée (16) de sorte qu'un mouvement des dents de l'au moins une roue dentée (16) suffit pour générer, par l'intermédiaire de l'ensemble capteur magnétorésistif (31), des signaux suffisamment intenses qui sont suffisamment efficaces pour mesurer le mouvement de rotation de l'au moins une roue dentée (16).

2. Convoyeur à courroie (10) selon la revendication 1, **caractérisé en ce que** l'au moins une roue dentée (16) de l'entraînement (14) est reliée fixement à la roue à tenons (12), en particulier reliée par adhérence, de préférence soudée.

3. Convoyeur à courroie (10) selon l'une des revendications précédentes, **caractérisé en ce que** le premier dispositif formant capteur (30) est disposé par rapport à l'au moins une roue dentée (16) de sorte qu'il est associé radialement à l'au moins une roue dentée (16), l'au moins un ensemble capteur magnétorésistif (31) du premier dispositif formant capteur (30) étant associé à un côté périphérique de l'au moins une roue dentée (16) de sorte que les dents de l'au moins une roue dentée (16) sont entraînées au-delà de l'au moins un ensemble capteur magnétorésistif (31) du premier dispositif formant capteur (30) lors d'un mouvement de rotation de l'au moins une roue dentée (16).

4. Convoyeur à courroie (10) selon l'une des revendications précédentes, **caractérisé en ce que** l'au moins un ensemble capteur magnétorésistif (31) est conçu pour mesurer un changement d'une résistance électrique entraîné par l'effet GMR.

5. Convoyeur à courroie (10) selon l'une des revendications précédentes, **caractérisé en ce que** le premier dispositif formant capteur (30) comporte deux ensembles capteurs magnétorésistifs (31) tournés l'un par rapport à l'autre, en particulier de 45°.

6. Convoyeur à courroie (10) selon l'une des revendications précédentes, **caractérisé en ce que** le premier dispositif formant capteur (30) comporte au moins une carte de circuit (33) ayant au moins un bord (34), l'au moins un ensemble capteur magnétorésistif (31) étant disposé sur la carte de circuit (33) avec une distance définie (35) par rapport à l'au moins un bord (34), et la distance définie (35) étant d'une précision inférieure à 0,150 mm, de préférence inférieure à 0,050 mm.

7. Convoyeur à courroie (10) selon la revendication 6, **caractérisé en ce que** l'entraînement (14) comporte au moins une surface de butée (17) et le premier dispositif formant capteur (30) est disposé de sorte que l'au moins un bord (34) de la carte de circuit (33) qui est en contact avec l'au moins une surface de butée (17), en particulier **en ce que** l'au moins un bord (34) de la carte de circuit (33) est pressé contre l'au moins une surface de butée (17).

8. Convoyeur à courroie (10) selon l'une des revendications précédentes, **caractérisé en ce que** le dispositif de détermination de position (20) comporte un second dispositif formant capteur (40) pour détecter une rotation complète de l'au moins une roue dentée (16) de l'entraînement (14) et/ou de la roue à tenons (12).

9. Convoyeur à courroie (10) selon la revendication 8, **caractérisé en ce que** le second dispositif formant capteur (40) comprend un capteur de lumière (41), en particulier un barrage photoélectrique à réflexion (42).

10. Machine d'insertion automatique (50), comportant au moins un convoyeur à courroie (10), **caractérisée en ce que** le convoyeur à courroie (10) est conçu selon l'une des revendications précédentes.
